# EUROPEAN PATENT SPECIFICATION

(11) **EP 1 815 310 B1**
(45) Date of publication and mention of the grant of the patent: **28.06.2017**
(21) Application number: 05815929.4
(22) Date of filing: 04.11.2005
(51) Int. Cl.: G06F 1/08, G11C 7/22, H03K 5/00

(54) **INTEGRATED CIRCUIT WITH ADAPTIVE SPEED BINNING**
INTEGRIERTE SCHALTUNG MIT GESCHWINDIGKEITSADAPTIVEM BINNING
CIRCUIT INTEGRE A SELECTION ADAPTATIVE DE CATEGORIE DE VITESSE

(30) Priority: 05.11.2004 US 625223 P
(43) Date of publication of application: 08.08.2007
(73) Proprietor: QUALCOMM INCORPORATED, San Diego, CA 92121 (US)
(72) Inventor: PATEL, Jagrut, V., San Diego, California 92109 (US); PRABHAKARAN, Rajeev, San Diego, California 92128 (US); KAPOOR, Sanat, San Diego, California 92122 (US); BULLARD, Gregory, La Mesa, CA 91941 (US)
(74) Representative: Tomkins & Co
(86) International application number: PCT/US2005/039952
(87) International publication number: WO 2006/052720

(56) References cited:
- WO-A-02/39629
- US-A- 6 011 749
- US-A1- 2003 005 346
- US-A1- 2004 049 708

## Description

### BACKGROUND

### Field

The present disclosure relates to systems and techniques for tuning an integrated circuit to an electronic component.

### Background

Integrated circuits have revolutionized the electronics industry by enabling new applications which were not possible with discrete devices. Integration allows complex circuits consisting of millions of electronic components to be packaged into a single chip of semiconductor material. In addition, integration offers the advantages of fabricating hundreds of chips on a single silicon wafer, which greatly reduces the cost and increases the reliability of each of the finished circuits.

Integrated circuits are widely used today in electronic devices to implement sophisticated circuitry such as general purpose and specific application processors. A controller integrated onto the chip may be used to interface the various processors with off-chip components, such as external memory and the like. Clocks generated by the controller may be used to access these off-chip components. These clocks should operate at a specific nominal speed, within a certain allowed tolerance, to ensure that the controller can communicate with the off-chip components under worst case temperature and voltage conditions.

Due to processes inherent in the silicon wafer fabrication process, a set of chips generated from a single wafer may fall into a range of different process speed ratings. Depending on the application, some manufacturers are forced to discard slow chips and fast chips that are outside of the nominal tolerance range. This leads to large amounts of waste, which can be very costly.

In an attempt to preserve those portions of the wafer that do not produce nominal chips, some manufacturers engage in a method of speed binning, in which the various chips produced from a single wafer are tested and batched according to their graded process speed. This method of batching chips according to their speed is time consuming and costly. Further cost is incurred as a result of selling slow chips and fast chips at reduced prices.

Speed binning has been a relatively static, up-front process which is generally useful in characterizing the performance capabilities of the integrated circuit. But thereafter, there is no ability for the integrated circuit to optimize its own performance or operating parameters as a function of the external device.

US patent publication number US2003005346, in the name of ZUMKEHR JOHN, discloses a system, method and medium to delay a strobe signal based upon a delay base and a delay adjustment to reduce effects of process variations and/or environmental changes.

US patent number US6011749, assigned to MOTOROLA INC, discloses a method and system for adjusting output timing in a memory device including the steps of receiving an external clock signal, measuring a frequency of the external clock signal, generating a frequency count, determining an output delay proportional to the frequency, and generating an output clock at the external frequency and delayed from the external clock signal in proportion to the frequency.

In one aspect of the invention, an electronic device is as set in independent claim 1.

In another aspect of the invention, a method is as set in independent claim 13.

It is understood that other embodiments of the present invention will become readily apparent to those skilled in the art from the following detailed description, wherein various embodiments of the invention are shown and described by way of illustration. As will be realized, the invention is capable of other and different embodiments and its several details are capable of modification in various other respects, all without departing from the scope of the present invention. Accordingly, the drawings and detailed description are to be regarded as illustrative in nature and not as restrictive.

### BRIEF DESCRIPTION OF THE DRAWINGS

Aspects of the present invention are illustrated by way of example, and not by way of limitation, in the accompanying drawings wherein:
FIG. 1 is a conceptual block diagram illustrating an example of an electronic device employing an integrated circuit;
FIG. 2 is a timing diagram illustrating an example of timing parameters to write to off-chip memory;
FIG. 3 is a timing diagram illustrating an example of timing parameters to read from off-chip memory;
FIG. 4 is a functional block diagram illustrating an example of the operation of a controller;
FIG. 5 is a flowchart illustrating an example of a method for determining frequency plans;
FIG. 6A is a plot showing HPV distributions as a function of frequency;
FIG. 7 is a flowchart illustrating a calibration algorithm useful for determining HPV; and
FIG. 8 is a representative flowchart illustrating an example of an adaptive speed binning algorithm.

### DETAILED DESCRIPTION

The detailed description set forth below in connection with the appended drawings is intended as a description of various embodiments of the present invention and is not intended to represent the only embodiments in which the present invention may be practiced. The detailed description includes specific details for the purpose of providing a thorough understanding of the present invention. However, it will be apparent to those skilled in the art that the present invention may be practiced without these specific details. In some instances, well-known structures and devices are shown in block diagram form in order to avoid obscuring the concepts of the present invention. Acronyms and other descriptive terminology may be used merely for convenience and clarity and are not intended to limit the scope of the invention.

In the following detailed description, various aspects of the present invention may be described in the context of an integrated circuit configured to couple to at least one storage device. The integrated circuit may be, for example, an Application Specific Integrated Circuit (ASIC) comprising at least one processor. The storage device may, for example, be a Synchronous Dynamic Random Access Memory (SDRAM) or similar device. While these inventive aspects may be well suited for use with these components, those skilled in the art will readily appreciate that these inventive aspects are likewise applicable for use in various other electronic devices or components. Accordingly, any reference to a specific type of integrated circuit or component (e.g., external or off-chip memory) is intended only to illustrate the inventive aspects, with the understanding that such inventive aspects have a wide range of applications.

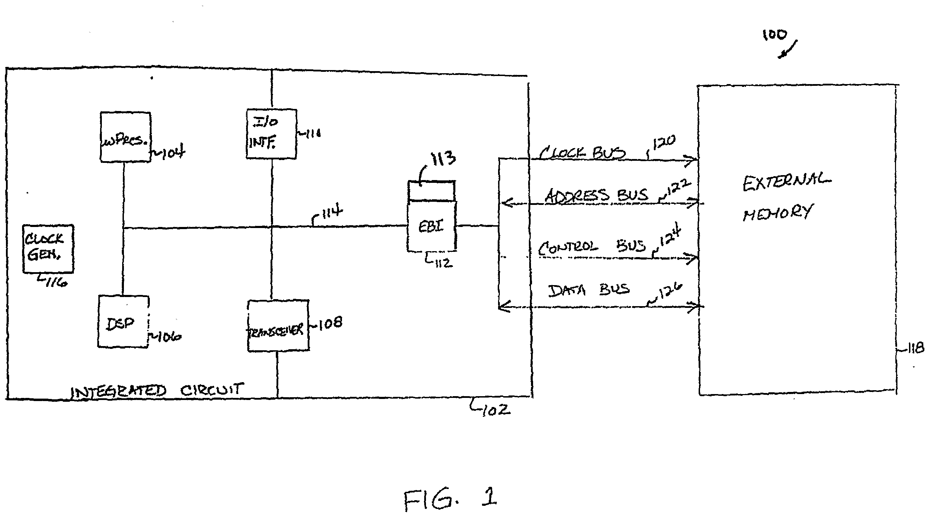

FIG. 1 is a conceptual block diagram of an electronic device 100 employing an integrated circuit 102, such as an ASIC. FIG. 1 should not be construed to require any particular physical layout of the electronic device 100. The integrated circuit 102 may include a microprocessor 104, a Digital Signal Processor (DSP) 106, a transceiver 108, an input/output (I/O) interface 110, and an External Bus Interface (EBI) 112. All these components may be coupled together with an Internal System Bus (ISB) 114. A clock generator 116 may be used to generate a system clock signal (or "system clock") for system timing. The frequency of the system clock may be programmable.

The microprocessor 104 may be used as a platform to run application programs that, among other things, provide user control and overall system management functions for the electronic device 100. The DSP 106 may be implemented with an embedded communications software layer which runs application specific algorithms to reduce the processing demands on the microprocessor 104. The transceiver 108 may be used to provide access to an external medium, such as a radio link in the case of a wireless telephone, terminal, e-mail or Web-enabled device, e.g., a Personal Data Assistant (PDA), or other similar device. In some embodiments, the transceiver 108 may provide access to Ethernet, cable modem line, fiber optics, Digital Subscriber Line (DSL), Public Switched Telephone Network (PSTN), or any other communications medium. In other embodiments, the electronic device may be self-contained without a transceiver to support external communications. The I/O interface 110 may be used to support various user interfaces. The user interfaces may include a keypad, mouse, touch screen, audio speaker or head set, microphone, camera and/or the like.

The EBI 112 may be used to provide access between the components on the ISB 114. The EBI 112 may include a controller 113 that provides an interface between the ISB 114 and other electronic components, e.g., one or more off-chip components, such as external memory 118. The interface may include a clock bus 120, an address bus 122, a control bus 124, and a data bus 126. Although not shown, the EBI 112 may also provide an interface to a Liquid Crystal Display (LCD) and/or other user interface devices.

In the following description of an electronic device, the external memory 118 will be a SDRAM. However, as those skilled in the art will readily appreciate, the various concepts described herein may be extended other off-chip components, including by way of example, other memory devices such as a Burst NOR, Burst PSRAM, RAM, ROM, EPROM, EEPROM, VRAM or any other memory component or device, or a memory array. The controller 113 may be used to generate an external clock signal (or "external clock") and a feedback clock signal (or "feedback clock") as a function of the system clock from clock generator 116. The external clock may be provided to the SDRAM over the clock bus 120 to read from and write to the external memory 118, hereafter SDRAM 118. The feedback clock may be used by the controller 113 to sample data read from the SDRAM 118.

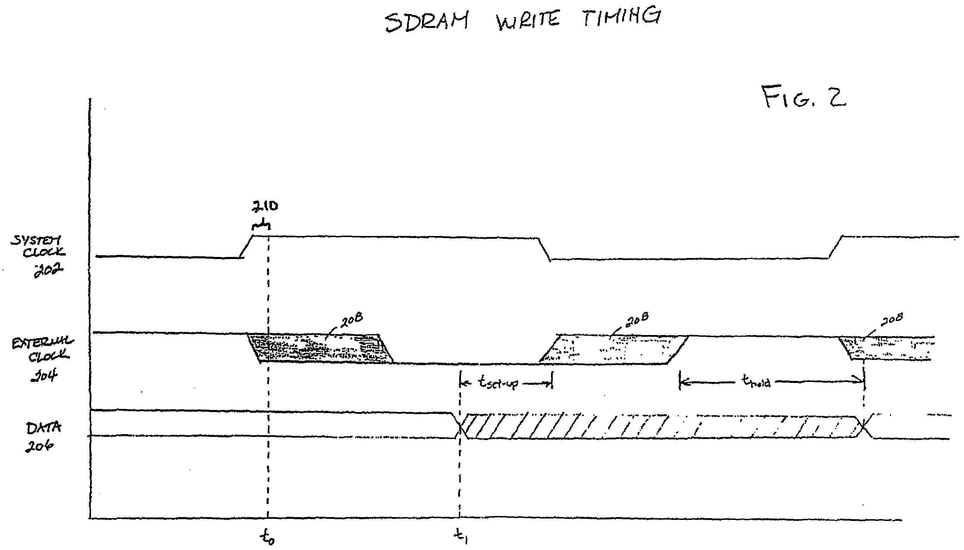

An example of the timing requirements to write to the SDRAM 118 is shown in FIG. 2. The external clock, which is represented by external clock 204, may be delayed from the system clock, which is represented by system clock 202. Data to be written to the SDRAM 118 is represented by data (or data signal) 206, and may be released onto the data bus 120 (see FIG. 1) from the controller 113 shortly after the transition of the system clock at time t₀. The short delay 210 between the transition of the system clock and t₀ is due to a propagation delay of the controller 113. The data bus 120 (see FIG. 1) adds additional propagation delay, causing the data 206 to arrive at the input to the SDRAM at time t₁. The data at the input to the SDRAM is shown in FIG. 2 with cross-hatching of data 206.

To ensure reliable operation, the data 206 must then be stable at the input to the SDRAM 118 for a brief period of time before the external clock transition. This is called the "minimum set-up time," and is denoted in FIG. 2 as tₛₑₜ₋ᵤₚ. There is also a period of time that the data 206 must remain stable following the external clock transition, i.e., after tₛₑₜ₋ᵤₚ. This is called the "minimum hold time," and is denoted in FIG. 2 as t_{hold}. If the minimum set-up and hold times are not met, then the write operation to the SDRAM cannot be guaranteed. Thus, one can readily see from FIG. 2 that there is a minimum delay requirement between the system clock 202 and the external clock 204 to meet the minimum set-up time, and a maximum delay between the two to meet the minimum hold time. The delay may be programmable, and can be set anywhere between these boundaries, as shown in FIG. 2 by the shaded portion 208 of external clock 204.

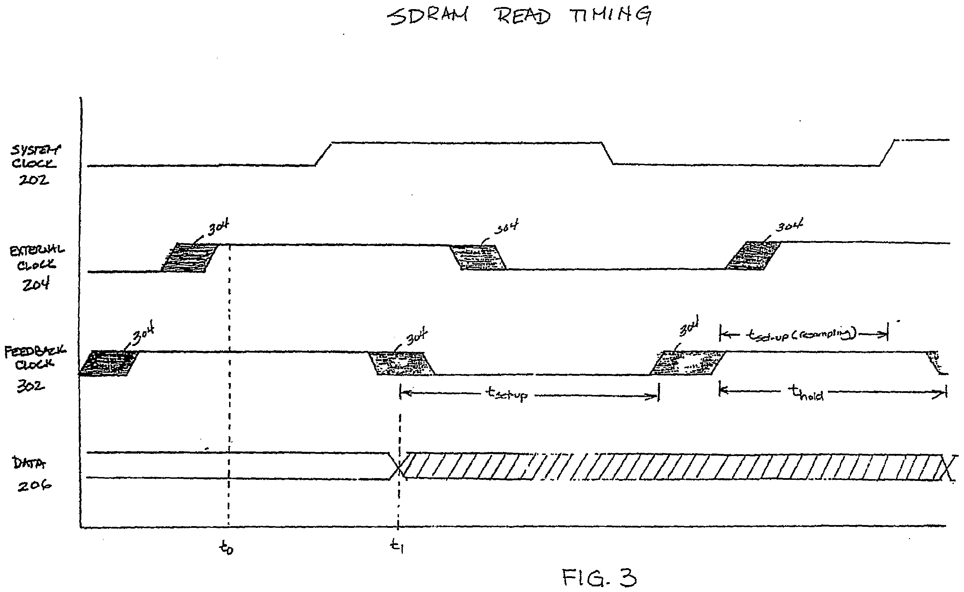

An example of the timing requirements to read from the SDRAM 118 is shown in FIG. 3. As explained earlier in connection with FIG. 2, the external clock 204 may be delayed from the system clock 202. The feedback clock 302 may also be delayed from the system clock 202 as shown in FIG. 3. The feedback clock 302 may be used to read the data from the SDRAM 118 into the controller 113. Data 206 may be released from the SDRAM 118 onto the data bus 120 (see FIG. 1) shortly after the transition of the external clock 204 at time t₀. Due to the propagation delay of the SDRAM 118 and the data bus 120 (see FIG. 1), the data 206 arrives at the input to the controller 113 at time t₁. The data at the input to the controller 113 (which is shown with cross-hatching of data 206) must remain stable for a brief period of time before the feedback clock transition. This period of time is defined by the minimum set-up time tₛₑₜ₋ᵤₚ of the controller 113.

The data 206 must also remain stable following the feedback clock 302 transition for a period of time defined by the minimum hold time t_{hold} of the controller 113. Once the data is read into the controller 113 with the transition of the feedback clock 302, it may be resampled by the system clock. The resampling process has its own requirements including a minimum set-up time in which the sampled data must remain stable before the next transition of the system clock 202. Thus, one can readily see from FIG. 3 that there is a minimum delay requirement between the system clock 202 and the feedback clock 302 to meet the minimum set-up time, and a maximum delay between the two to meet the minimum hold time and resampling set-up times. The delay may be programmable in the controller 113, and can be set anywhere between these boundaries, as shown in FIG. 3 by the shaded portion 304.

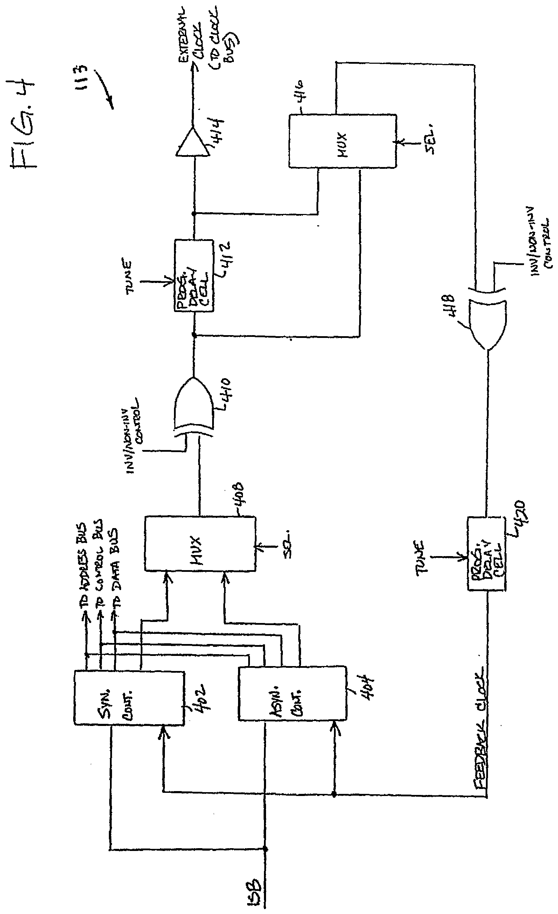

FIG. 4 is a functional block diagram of an embodiment of a controller 113. In the embodiment shown, the controller 113 may be divided into a synchronous controller 402 and an asynchronous controller 404. This division is merely a design preference and those skilled in the art will readily understand that any configuration may be employed to perform the various functions described throughout this disclosure. The controllers 402 and 404 may be configured to interface the address bus 122, control bus 124, and data bus 126 to the ISB 114 by means well known in the art.

The controller 113 may be used to generate the external clock 204 and feedback clock 302. A multiplexer 408 may be used to select the appropriate system clock 202 depending on whether the data 206 is clocked out of the synchronous or asynchronous controller. In the embodiment shown, the multiplexer 408 may be set to select the system clock used by the synchronous controller 402 to interface to the SDRAM 118. An exclusive OR gate 410 may be used to provide flexibility by using either the inverted or non-inverted system clock 202 to generate the external and feedback clocks. A programmable delay cell 412 may be used to set the delay of the external clock 204. The multiplexer and exclusive OR gate controls, as well as the delay of the external clock, may be programmed by, for example, software running on the microprocessor 104, or by any other means. A bus driver 414 may be used to provide the external clock 204 to the SDRAM 118.

The feedback clock 302 may be generated from either the system clock 202 or the external clock 204. In the described embodiment, both clocks may be provided to a multiplexer 416 to provide some versatility to the software programmer. The selected system clock may be provided to an exclusive OR gate 418. The exclusive OR gate 418 allows either the inverted or non-inverted clock to be used. A programmable delay cell 420 may be used to delay the feedback clock. The feedback clock 302 may then be fed back to the controllers 402 and 404. The multiplexer and exclusive OR gate controls, as well as the delay of the feedback clock, may be programmed by software running on the microprocessor 104, or by any other means.

As discussed earlier, certain timing constraints imposed by the controller 113 and the SDRAM 118 may limit the possible delay settings for the external and feedback clocks. The delay setting for the external clock, for example, may be constrained by the minimum set-up and hold times for the SDRAM 118. Similarly, the delay setting for the feedback clock may be constrained by the minimum set-up, hold and resampling set-up times for the controller. These timing constraints can vary with process, temperature and voltage.

The delay settings for the external and feedback clocks may be programmed during a characterization procedure prior to shipment of the integrated circuits, e.g., at the factory. This process may entail the collection of characterization data for the integrated circuit across process, voltage and temperature variations. The delay settings may then be computed in a worst case analysis from the characterization data and the timing specifications for the external device. These computed delay settings may be used to calibrate the programmable delay cells on the controller for such integrated circuits before shipment, as preprogrammed delays.

Additionally, limitations my be imposed on the maximum frequency of the system clock (referred to as "FMAX") to prevent errors caused by the system clock running faster then a particular integrated circuit and off-chip component in the field can accommodate. Typically, when constraints on FMAX are imposed they tend to cause the system clock to be run at a relatively slow frequency to accommodate the widest possible range of electronic devices. This approach of preprogramming the delays and FMAX may work quite well for one particular process corner, but may not work well for others. For example, in cases where a specific electronic device could operate at a higher frequency, having FMAX preprogrammed at a slow frequency causes the electronic device to operate sub-optimally.

In accordance with the illustrative embodiment, an adaptive speed binning algorithm (or process) may be implemented that allows the frequency (i.e., FMAX) and clock delays to be set on a device-specific basis. The adaptive speed binning algorithm may rely on a set of "frequency plans" determined from statistical information for a sufficiently large sample of electronic devices from a particular family of electronic devices, e.g., for a certain type of integrated circuit and off-chip component. The statistical information may be gathered during a characterization process performed at the factory. The set of frequency plans may be stored in the electronic device prior to shipment. In the field, the adaptive speed binning algorithm selects and implements an appropriate frequency plan for the specific electronic device. In the illustrative embodiment, each frequency plan comprises an FMAX value and an external clock delay value. The adaptive speed binning algorithm may be embodied in software, or implemented in any other manner, and may be executed at first boot up, every time the electronic device boots up, continuously during operation of the electronic device, in response to a sensed event or condition, or any combination of the foregoing.

The characterization process may begin with the computation of the delay ("*K*") between the feedback clock and the external clock for a sample of electronic devices. Returning to FIG. 3, one can readily see that the set-up time tₛₑₜ₋ᵤₚ for the controller 113 is based on the delay from the transition of the external clock to the transition of the feedback clock, for the read operation. One can also see that the hold time t_{hold} is based on the delay from the transition of the feedback clock to the next transition of the external clock. Accordingly, if the delay between the external clock and the feedback clock is reduced, the set-up time tₛₑₜ₋ᵤₚ decreases and the hold time t_{hold} increases. Conversely, if the delay between the external clock and the feedback clock is increased, the set-up time tₛₑₜ₋ᵤₚ increases and the hold time t_{hold} decreases. Thus, the initial step of the characterization process may be to compute a delay between the feedback clock and the external clock that satisfies the worst case minimum set-up and hold times of the controller 113 for the sample of electronic devices.

Assuming that the delay between the feedback and external clock device is set to satisfy the minimum set-up and hold times of the controller during the read operation, then the failure or success of a read operation will depend entirely on whether the minimum resampling set-up time tₛₑₜ₋ᵤₚ is satisfied. Referring to FIG. 3, the resampling set-up time tₛₑₜ₋ᵤₚ is very long when the delay between the system clock and the feedback clock is small. However, as the delay between the two clocks is increased, the resampling set-up time tₛₑₜ₋ᵤₚ decreases until it reaches the minimum resampling set-up time tₛₑₜ₋ᵤₚ. This is the "maximum delay" between the system clock and feedback clock in which the read operation can be guaranteed. Because the external clock is delayed from the system clock with a fixed offset from the feedback clock, the external clock also has a "maximum delay" from the system clock in which the operation can be guaranteed. The "maximum delay" between the system clock and the external clock will be referred to as the "highest passing value" (HPV).

Returning to FIG. 2, the success or failure of a write operation will depend on two timing parameters: the minimum set-up time tₛₑₜ₋ᵤₚ and the minimum hold time t_{hold} for writing to the SDRAM 118. As a practical matter, however, the minimum hold time t_{hold} is normally not a limiting factor. This is because the hold time is approximately equal to the clock period less the set-up time tₛₑₜ₋ᵤₚ, which is much larger than the minimum hold time t_{hold}, Accordingly, the minimum set up time tₛₑₜ₋ᵤₚ of the SDRAM 118 will determine the "minimum delay" between the system clock and the external clock in which the write operation can be guaranteed. This "minimum delay" will be referred to the "lowest passing value" (LPV).

During the characterization process, a test procedure may be performed on each electronic device in the sample to determine a range of delay values between the system clock and the external clock in which the controller 113 can write to and read from the SDRAM 118. This range is a continuous range bound by a "maximum delay" set by the minimum resampling set-up time tₛₑₜ₋ᵤₚ time of the controller 113 and a "minimum delay" set by the minimum set up time tₛₑₜ₋ᵤₚ of the SDRAM 118. The testing procedure may involve programming the computed delay between the feedback clock and the external clock into the programmable delay cells of the controller 113 for each of the electronic devices under test. Next, the tuning range of the programmable delay cells for each electronic device may be swept across the entire tuning range, while maintaining the delay between the feedback and external clock. More specifically, for each electronic device, the programmable delay cell 412 for the external clock may be set to zero delay and the programmable delay cell 420 for the feedback clock may be set to *-K.* The delay of the programmable delay cells may then be incrementally increased together. For each incremental delay, the controller 113 reads from and writes to the SDRAM 118, and then classifies each read and write attempt as a failure or success depending on the outcome. This may be done at each FMAX, e.g., slow, nominal and fast.

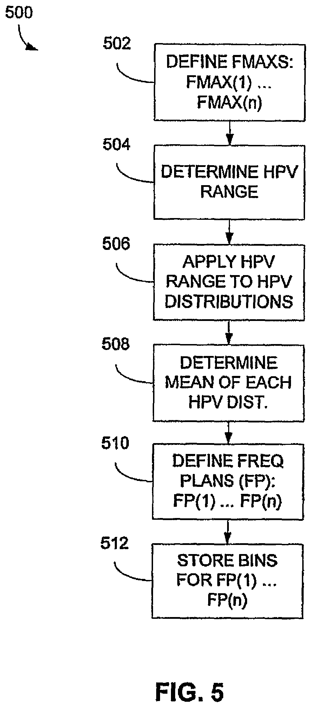

FIG. 5 is a representative flowchart 500 that illustrates a method of determining and storing the frequency plans for a family of electronic devices during the characterization process. In step 502, the values of FMAX are set. Here, three FMAX values are used: a slow, nominal, and fast. Nominal is generally assumed to be about the middle frequency from the range of frequencies at which the electronic device can operate. In step 504 an HPV range is determined for each FMAX, e.g., as discussed above.

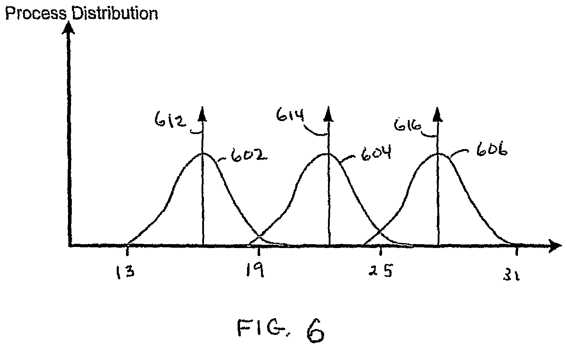

The HPV range is determined from the HPV for all electronic devices in the sample. FIG. 6 is a graph 600 showing the HPV distributions for all electronic devices in the sample. The number of devices having a specific HPV is plotted against the tuning range of the delay between the system clock and the external clock, which in this case is represented in the digital domain as 0-31. Graph 600 shows three different process distributions of HPVs, one at each of three frequencies: fast, nominal, and slow from step 502. Typically, the center of the range of operating frequencies for the integrated circuit is the nominal frequency and the approximate highest frequency is the fast frequency and the approximate lowest frequency is the slow frequency. In the illustrative embodiment, a slow frequency may be about 146 MHz, a nominal frequency may be about 210 MHz, and a fast frequency may be at about 270 MHz. These three frequencies represent different frequencies at which the controller of the integrated circuit may operate when communicating with the SDRAM. In FIG. 6A the HPV range has been determined to be *n*=13-31.

In FIG. 6A, distribution 602 corresponds to FMAX being Slow; distribution 604 corresponds to FMAX being Nominal; and distribution 603 corresponds to FMAX being Fast. The distributions are generally known in the art of integrated circuits, so not discussed in detail herein. Therefore, while other electronic devices may have different slow, nominal and fast frequencies, the distributions of FIG. 6A would still be generally applicable. However, the HPV range of the x-axis is specific to a particular family of electronic devices and generally not known. Therefore, once an HPV range is determined, the distributions can be fit to the HPV range, as in step 506.

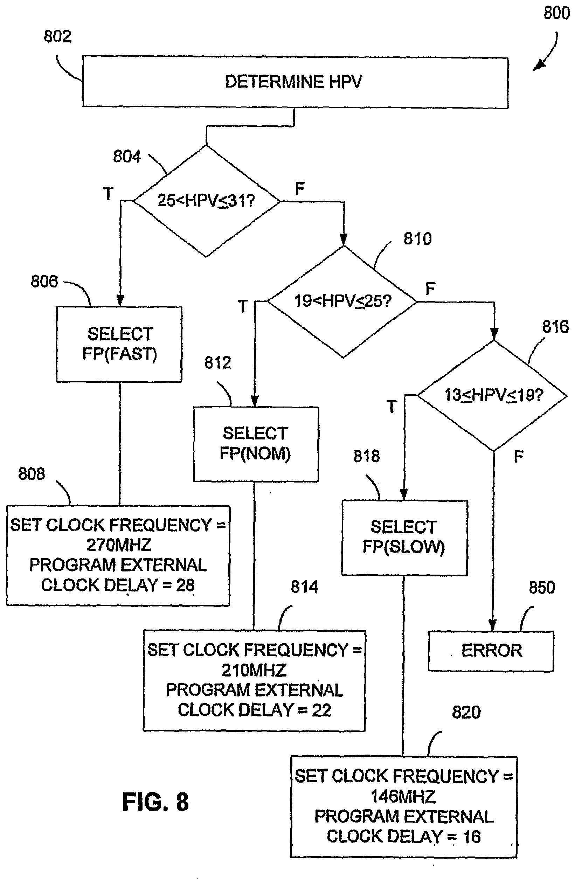

The process distributions in FIG. 6 take the form of bell curves, where adjacent bell curves overlap near the x-axis. The HPV range is divided into "bins" whose boundaries are defined at the bell curve overlaps. The bins are about the same width, here each about 6 delay units in width. The bins are later used in forming the frequency plans and are also used by the adaptive speed binning algorithm of FIG. 8.

Returning to FIG. 5, in step 508 the mean HPV value is determined for each bin. For example, in FIG. 6 for distribution 602, the mean, represented by arrow 612, is at about HPV = 16. For distribution 604, the mean, represented by arrow 614, is at about HPV = 22. And for distribution 606, the mean, represented by arrow 612, is at about HPV = 28.

In step 510, a frequency plan (FP) is defined for each FMAX defined in step 502. In the illustrative embodiment, each frequency plan is associated with a bin. The frequency plan includes FMAX, an HPV bin width for the corresponding FMAX and a feedback clock delay equal to the mean HPV value for the corresponding bin. FMAX will be used to set the system clock frequency upon selection of a frequency plan defined for a given bin. Once the frequency plans are defined they can be stored, in step 512, for later use by the adaptive speed binning algorithm of FIG. 8, later described herein. In this embodiment, the bins and frequency plans may be defined as follows:
Bin 1, FP(fast): 25<HPV≤31, external clock delay=28, set frequency @ 270MHz
Bin 2, FP(nom): 19<HPV≤25, external clock delay=22, set frequency @ 210MHz
Bin 3, FP(slow): 13≤HPV≤19, external clock delay=16, set frequency @ 146MHZ
While three frequencies, and thus three frequency plans, are defined in this embodiment, a different number of frequencies and frequency plans could be used in other embodiments.

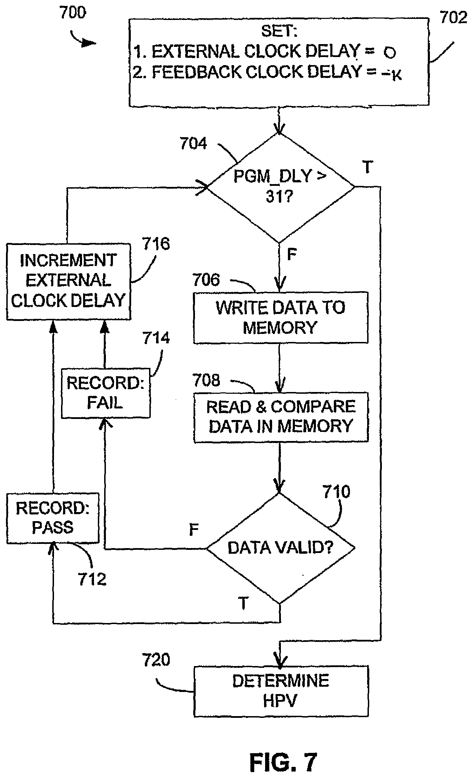

Generally, it is preferred to run at the highest speed possible, while maintaining reliable operation. With the frequency plans and bins defined above, electronic devices can be shipped and the adaptive speed binning algorithm (see FIG. 8) used in the field to set the speed of the electronic device to an optimal setting, using the appropriate frequency plan. In the illustrative embodiment, the adaptive speed binning algorithm takes as an input, the HPV of the electronic device 100. Here, the HPV of electronic device 100 may be determined in the field using the calibration algorithm 700 of FIG. 7.

The calibration algorithm 700 is similar to the algorithm used to characterization process to determine the HPV range over a family of electronic devices. The calibration algorithm 700 produces a value of HPV that is used by the adaptive speed binning algorithm 800 of FIG. 8. The calibration algorithm 700 may be run at the first boot-up of the electronic device 100 and may serve as a first, or preprocessing, stage of the speed binning algorithm 800 of FIG. 8. The calibration algorithm 700 may also be run at subsequent boot-ups, randomly, periodically, or in response to a variation to a sensed condition, e.g., voltage, temperature, or speed. In such a case, the adaptive speed binning algorithm 800 of FIG. 8 may also be run.

In the illustrative embodiment, the integrated circuit 102 may be a fixed voltage device and the frequency may be set to a nominal value for calibration. During calibration neither the frequency nor voltage need to be varied. In other embodiments, the integrated circuit 102 may be configured to run at more than one voltage setting. In such cases, the calibration algorithm may be performed at more than one voltage, or just at the preferred voltage.

In this example, the calibration algorithm initially sets the delay between the system clock and the external clock to zero (*nₑₓₜ*=0), and the delay between the system clock and the feedback clock to *-K*(*nₑₓₜ*=-*K*) in step 702. Step 704 tests whether the external clock has been swept through the entire tuning range. This may be achieved by determining whether *nₑₓₜ* is greater than 31. Assuming the external clock delay has not been swept across the entire tuning range, in step 704, the process 700 continues to step 706, where the integrated circuit writes test data to SDRAM. The process 700 then continues to step 708, where the integrated circuit reads the test data from SDRAM.

The test data that is read is compared to that which was written. If, in step 710, the read data is valid (i.e., correct), then the process 700 continues to step 712 and a "pass" condition is noted for the operation at the external clock setting. If the read data did not match that which was written, then the test failed and a "fail" condition is recorded for the external clock setting, in step 714. In either case, the external clock delay value is incremented in step 716 (along with the feedback clock delay value), and the process 700 returns to step 704. In this manner, the calibration algorithm 700 sweeps the entire delay range. Once complete, the process 700 continues to step 720, where the HPV for the electronic device is determined.

Once the HPV for the specific electronic device is known, the adaptive speed binning algorithm may be performed to set the system clock frequency and external clock delay from a corresponding frequency plan, which may be stored with respect to bins. FIG. 8 is a flowchart 800 depicting an adaptive speed binning algorithm, as a method that may be implemented by an electronic device to determine and implement a frequency plan from a set of predetermined frequency plans useful with an off-chip component. In this embodiment, the set of frequency plans is stored to be accessible by integrated circuit when coupled to SDRAM.

In step 802, the HPV for the specific electronic device is determined (or obtained if already known). As an example, the HPV value may be determined using the above described calibration algorithm using the nominal voltage and frequency setting and the predetermined value of *K*. Given the HPV, a series of tests may be performed to see which frequency plan is to be implemented. In step 804, a determination is made of whether or not the HPV falls within the HPV range of bin 1, i.e., is the HPV greater than 25 and less than or equal to 31. If the outcome in step 804 was "true", then the electronic device is considered to be "fast". The process continues to step 806 where the frequency plan FP(fast) is selected. The integrated circuit then sets the system clock to run at 270MHz and the external clock delay to 28 in step 808.

If the outcome of step 804 was "false", the process proceeds to step 810. In this step, if HPV is greater than 19 and less than or equal to 25, then the electronic device is a "nominal" device and the process continues to step 812, where the frequency plan FP(nom) is selected. The integrated circuit then sets the system clock to run at 210MHz and the external clock delay to 22.

If the outcome of step 810 was "false", the process proceeds to step 816. In this step, if HPV is greater than or equal to 13 and less than or equal to 19, then the electronic device is a "slow" device and the process continues to step 818, where the frequency plan FP(slow) is selected. The integrated circuit then sets the system clock to run at 146MHz and the external clock delay to 16 in step 820. If the outcome in step 816 is "false" then an error condition occurs, represented in step 850. For example, if the HPV was below 13, an error would occur. The calibration algorithm 700 and speed binning algorithm 800 could be rerun in such a case.

The various illustrative logical blocks, modules, and circuits described in connection with the embodiments disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The methods or algorithms described in connection with the embodiments disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. A storage medium may be coupled to the processor such that the processor can read information from, and write information to, the storage medium. In the alternative, the storage medium may be integral to the processor. The processor and the storage medium may reside in an ASIC. The ASIC may reside in the terminal, or elsewhere. In the alternative, the processor and the storage medium may reside as discrete components in the integrated circuit, or elsewhere.

The previous description of the disclosed embodiments is provided to enable any person skilled in the art to make or use the present invention. Various modifications to these embodiments will be readily apparent to those skilled in the art, and the generic principles defined herein may be applied to other embodiments without departing from the scope of the invention. Thus, the present invention is not intended to be limited to the embodiments shown herein but is to be accorded the widest scope consistent with the principles and novel features disclosed herein.

## Claims

1. An electronic device, comprising:
an electronic component; and
an integrated circuit configured to generate a system clock having a programmable frequency, and an external clock having a programmable delay from the system clock, **characterised in that** the integrated circuit being further configured to:
provide the external clock to the electronic component,
determine the maximum delay from a maximum delay range between the system clock and the external clock in which the integrated circuit and the electronic component can communicate,
set the external clock delay and the frequency of the system clock, based on a comparison between the maximum delay and a plurality of predetermined range bins.

2. The device of claim 1 wherein the integrated circuit is further configured to program the frequency of the system clock based on a frequency plan associated with one of the plurality of predetermined range bins.

3. The device of claim 2 wherein the integrated circuit is further configured to program the frequency of the system clock with a predetermined frequency from the frequency plan.

4. The device of claim 3 wherein the integrated circuit is further configured to store the frequency plan.

5. The device of claim 3 wherein each of the predetermined frequencies is related to a plurality of delay range upper boundaries characterizing the electronic device.

6. The device of claim 1 wherein the integrated circuit is further configured to program the external clock with a delay included in the frequency plan

7. The device of claim 6 wherein the integrated circuit is further configured to generate a feedback clock having a programmable delay from the system clock, the feedback clock being used to receive communications from the electronic component, and wherein the integrated circuit is further configured to program the feedback clock with a delay having a constant offset from the external clock.

8. The device of claim 6 wherein the integrated circuit is further configured to program the external clock with a feedback clock delay included in the frequency plan.

9. The device of claim 8 wherein the integrated circuit is further configured to store the feedback delay values.

10. The device of claim 1 wherein the electronic component comprises at least one memory device.

11. The device of claim 1 wherein the electronic component comprises at least one SDRAM, Burst NOR, Burst PSRAM, RAM, ROM, EPROM, EEPROM, or VRAM.

12. The device of claim 1 wherein the electronic device comprises a wireless telephone, personal digital assistant, e-mail device, or Web enabled device.

13. A method of adapting an integrated circuit to an electronic component, the method comprising:
generating a system clock having a programmable frequency, and an external clock having a programmable delay from the system clock;
providing the external clock to the electronic component;
**characterised by** the steps of: determining the maximum delay between the system clock and the external clock in which the integrated circuit and the electronic component can communicate; setting the external clock delay and the frequency of the system clock based on a comparison between the maximum delay and a plurality of predetermined range bins.

14. The method of claim 13 wherein the frequency of the system clock is programmed based on a frequency plan associated with one of the plurality of predetermined range bins.

15. The method of claim 14wherein the frequency of the system clock is programmed with a predetermined frequency from the frequency plan.

16. The method of claim 15 wherein the frequency plan is predetermined stored by the integrated circuit.

17. The method of claim 13 further comprising programming the external clock with a delay included in the frequency plan.

18. The method of claim 13 further comprising generating a feedback clock having a programmable delay from the system clock, using the feedback clock at the integrated circuit to receive communications from the electronic component, and programming the feedback clock with a delay having a constant offset from the external clock.

19. The method of claim 17 wherein the external clock is programmed with one of a plurality of predetermined feedback clock delay values included in the frequency plan.

20. The method of claim 19 wherein the predetermined feedback clock delay values are stored by the integrated circuit.

21. The method of claim 13 wherein the electronic component comprises at least one memory device.

22. The method of claim 13 wherein the electronic component comprises at least one SDRAM, Burst NOR, Burst PSRAM, RAM, ROM, EPROM, EEPROM, or VRAM.

23. The method of claim 13 wherein the electronic device comprises a wireless telephone, personal digital assistant, e-mail device, or Web enabled device.

## Patentansprüche

1. Ein elektronisches Gerät, aufweisend:
eine elektronische Komponente, und
eine integrierte Schaltung, die konfiguriert ist zum Generieren eines Systemtakts mit einer programmierbaren Frequenz und eines externen Takts mit einer programmierbaren Verzögerung von dem Systemtakt,
**dadurch gekennzeichnet, dass** die integrierte Schaltung weiterhin konfiguriert ist zum:
Vorsehen des externen Takts zu der elektronischen Komponente,
Bestimmen der maximalen Verzögerung aus einem maximalen Verzögerungsbereich zwischen dem Systemtakt und dem externen Takt, in dem die integrierte Schaltung und die elektronische Komponente kommunizieren können, und
Setzen der externen Taktverzögerung und der Frequenz des Systemtakts basierend auf einem Vergleich zwischen der maximalen Verzögerung und einer Vielzahl von vorbestimmten Bereichs-Bins.

2. Gerät nach Anspruch 1, wobei die integrierte Schaltung weiterhin konfiguriert ist zum Programmieren der Frequenz des Systemtakts basierend auf einem Frequenzplan, der mit einem aus der Vielzahl von vorbestimmten Bereichs-Bins assoziiert ist.

3. Gerät nach Anspruch 2, wobei die integrierte Schaltung weiterhin konfiguriert ist zum Programmieren der Frequenz des Systemtakts mit einer vorbestimmten Frequenz aus dem Frequenzplan.

4. Gerät nach Anspruch 3, wobei die integrierte Schaltung weiterhin konfiguriert ist zum Speichern des Frequenzplans.

5. Gerät nach Anspruch 3, wobei jede der vorbestimmten Frequenzen auf eine Vielzahl von Verzögerungsbereich-Obergrenzen, die das elektronische Gerät kennzeichnen, bezogen ist.

6. Gerät nach Anspruch 1, wobei die integrierte Schaltung weiterhin konfiguriert ist zum Programmieren des externen Takts mit einer in dem Frequenzplan enthaltenen Verzögerung.

7. Gerät nach Anspruch 6, wobei die integrierte Schaltung weiterhin konfiguriert ist zum Generieren eines Feedback-Takts mit einer programmierbaren Verzögerung von dem Systemtakt, wobei der Feedback-Takt verwendet wird, um Kommunikationen von der elektronischen Komponente zu empfangen, und wobei die integrierte Schaltung weiterhin konfiguriert ist zum Programmieren des Feedback-Takts mit einer Verzögerung, die einen konstanten Versatz von dem externen Takt aufweist.

8. Gerät nach Anspruch 6, wobei die integrierte Schaltung weiterhin konfiguriert ist zum Programmieren des externen Takts mit einer Feedback-Taktverzögerung, die in dem Frequenzplan enthalten ist.

9. Gerät nach Anspruch 8, wobei die integrierte Schaltung weiterhin konfiguriert ist zum Speichern der Feedback-Verzögerungswerte.

10. Gerät nach Anspruch 1, wobei die elektronische Komponente wenigstens eine Speichereinrichtung aufweist.

11. Gerät nach Anspruch 1, wobei die elektronische Komponente ein SDRAM, Burst-NOR, Burst-PSRAM, RAM, ROM, EPROM, EEPROM und/oder VRAM ist.

12. Gerät nach Anspruch 1, wobei das elektronische Gerät ein drahtloses Telefon, ein PDA, ein E-Mail-Gerät oder ein internetfähiges Gerät ist.

13. Ein Verfahren zum Anpassen einer integrierten Schaltung an eine elektronische Komponente, wobei das Verfahren aufweist:
Generieren eines Systemtakts mit einer programmierbaren Frequenz und eines externen Takts mit einer programmierbaren Verzögerung von dem Systemtakt,
Vorsehen des externen Takts zu der elektronischen Komponente,
**gekennzeichnet durch** die folgenden Schritte:
Bestimmen der maximalen Verzögerung zwischen dem Systemtakt und dem externen Takt, in dem die integrierte Schaltung und die elektronische Komponente kommunizieren können, und
Setzen der externen Taktverzögerung und der Frequenz des Systemtakts basierend auf einem Vergleich zwischen der maximalen Verzögerung und einer Vielzahl von vorbestimmten Bereichs-Bins.

14. Verfahren nach Anspruch 13, wobei die Frequenz des Systemtakts basierend auf einem Frequenzplan, der mit einem aus der Vielzahl von vorbestimmten Bereichs-Bins assoziiert ist, programmiert wird.

15. Verfahren nach Anspruch 14, wobei die Frequenz des Systemtakts mit einer vorbestimmten Frequenz aus dem Frequenzplan programmiert wird.

16. Verfahren nach Anspruch 15, wobei der Frequenzplan vorbestimmt durch die integrierte Schaltung gespeichert wird.

17. Verfahren nach Anspruch 13, das weiterhin das Programmieren des externen Takts mit einer in dem Frequenzplan enthaltenen Verzögerung aufweist.

18. Verfahren nach Anspruch 13, das weiterhin aufweist: Generieren eines Feedback-Takts mit einer programmierbaren Verzögerung von dem Systemtakt, Verwenden des Feedback-Takts an der integrierten Schaltung, um Kommunikationen von der elektronischen Komponente zu empfangen, und Programmieren des Feedback-Takts mit einer Verzögerung, die einen konstanten Versatz von dem externen Takt aufweist.

19. Verfahren nach Anspruch 17, wobei der externe Takt mit einem aus einer Vielzahl von vorbestimmten Feedback-Takt-Verzögerungswerten die in dem Frequenzplan enthalten sind, programmiert wird.

20. Verfahren nach Anspruch 19, wobei die vorbestimmten Feedback-Takt-Verzögerungswerte durch die integrierte Schaltung gespeichert werden.

21. Verfahren nach Anspruch 13, wobei die elektronische Komponente wenigstens eine Speichereinrichtung aufweist.

22. Verfahren nach Anspruch 13, wobei die elektronische Komponente ein SDRAM, Burst-NOR, Burst-PSRAM, RAM, ROM, EPROM, EEPROM und/oder VRAM ist.

23. Verfahren nach Anspruch 13, wobei das elektronische Gerät ein drahtloses Telefon, ein PDA, ein E-Mail-Gerät oder ein internetfähiges Gerät ist.

## Revendications

1. Dispositif électronique, comprenant :
un composant électronique ; et
un circuit intégré configuré pour générer une horloge de système ayant une fréquence programmable, et une horloge externe ayant un retard programmable par rapport à l'horloge de système, **caractérisé en ce que** le circuit intégré est en outre configuré pour :
fournir l'horloge externe au composant électronique,
déterminer le retard maximum à partir d'une plage de retard maximum entre l'horloge de système et l'horloge externe dans laquelle le circuit intégré et le composant électronique peuvent communiquer,
établir le retard d'horloge externe et la fréquence de l'horloge de système, sur la base d'une comparaison entre le retard maximum et une pluralité de fenêtres d'étendue de plage prédéterminées.

2. Dispositif selon la revendication 1, dans lequel le circuit intégré est en outre configuré pour programmer la fréquence de l'horloge de système sur la base d'un plan de fréquence associé à l'une de la pluralité de fenêtres d'étendue de plage prédéterminées.

3. Dispositif selon la revendication 2, dans lequel le circuit intégré est en outre configuré pour programmer la fréquence de l'horloge de système avec une fréquence prédéterminée provenant du plan de fréquence.

4. Dispositif selon la revendication 3, dans lequel le circuit intégré est en outre configuré pour mémoriser le plan de fréquence.

5. Dispositif selon la revendication 3, dans lequel chacune des fréquences prédéterminées est liée à une pluralité de limites supérieures de plage de retard caractérisant le dispositif électronique.

6. Dispositif selon la revendication 1, dans lequel le circuit intégré est en outre configuré pour programmer l'horloge externe avec un retard inclus dans le plan de fréquence.

7. Dispositif selon la revendication 6, dans lequel le circuit intégré est en outre configuré pour générer une horloge de rétroaction ayant un retard programmable par rapport à l'horloge de système, l'horloge de rétroaction étant utilisée pour recevoir des communications du composant électronique, et dans lequel le circuit intégré est en outre configuré pour programmer l'horloge de rétroaction avec un retard ayant un décalage constant par rapport à l'horloge externe.

8. Dispositif selon la revendication 6, dans lequel le circuit intégré est en outre configuré pour programmer l'horloge externe avec un retard d'horloge de rétroaction inclus dans le plan de fréquence.

9. Dispositif selon la revendication 8, dans lequel le circuit intégré est en outre configuré pour mémoriser les valeurs de retard de rétroaction.

10. Dispositif selon la revendication 1, dans lequel le composant électronique comprend au moins un dispositif de mémoire.

11. Dispositif selon la revendication 1, dans lequel le composant électronique comprend au moins une mémoire SDRAM, une Burst NOR, une Burst PSRAM, une RAM, une ROM, une EPROM, une EEPROM, ou une VRAM.

12. Dispositif selon la revendication 1, dans lequel le dispositif électronique comprend un téléphone sans fil, un assistant numérique personnel, un dispositif de courrier électronique, ou un dispositif compatible Web.

13. Procédé d'adaptation d'un circuit intégré à un composant électronique, le procédé comprenant :
la génération d'une horloge de système ayant une fréquence programmable, et d'une horloge externe ayant un retard programmable par rapport à l'horloge de système;
la fourniture de l'horloge externe au composant électronique ;
**caractérisé par** les étapes : de détermination du retard maximum entre l'horloge de système et l'horloge externe pendant lequel le circuit intégré et le composant électronique peuvent communiquer ; d'établissement du retard d'horloge externe et de la fréquence de l'horloge de système sur la base d'une comparaison entre le retard maximum et une pluralité de fenêtres d'étendue de plage prédéterminées.

14. Procédé selon la revendication 13, dans lequel la fréquence de l'horloge de système est programmée sur la base d'un plan de fréquence associé à l'une de la pluralité de fenêtres d'étendue de plage prédéterminées.

15. Procédé selon la revendication 14, dans lequel la fréquence de l'horloge de système est programmée avec une fréquence prédéterminée provenant du plan de fréquence.

16. Procédé selon la revendication 15, dans lequel le plan de fréquence est prédéterminé et mémorisé par le circuit intégré.

17. Procédé selon la revendication 13, comprenant en outre la programmation de l'horloge externe avec un retard inclus dans le plan de fréquence.

18. Procédé selon la revendication 13, comprenant en outre la génération d'une horloge de rétroaction ayant un retard programmable par rapport à l'horloge de système, l'utilisation de l'horloge de rétroaction au niveau du circuit intégré pour recevoir des communications provenant du composant électronique, et la programmation de l'horloge de rétroaction avec un retard ayant un décalage constant par rapport à l'horloge externe.

19. Procédé selon la revendication 17, dans lequel l'horloge externe est programmée avec l'une d'une pluralité de valeurs de retard d'horloge de rétroaction prédéterminées incluses dans le plan de fréquence.

20. Procédé selon la revendication 19, dans lequel les valeurs de retard d'horloge de rétroaction prédéterminées sont mémorisées par le circuit intégré.

21. Procédé selon la revendication 13, dans lequel le composant électronique comprend au moins un dispositif de mémoire.

22. Procédé selon la revendication 13, dans lequel le composant électronique comprend au moins une mémoire SDRAM, une Burst NOR, une Burst PSRAM, une RAM, une ROM, une EPROM, une EEPROM, ou une VRAM.

23. Procédé selon la revendication 13, dans lequel le dispositif électronique comprend un téléphone sans fil, un assistant numérique personnel, un dispositif de courrier électronique, ou un dispositif compatible Web.
